## Europäisches Patentamt
## European Patent Office
## Office européen des brevets

(11) Numéro de publication: **0 386 840**

**A1**

## (12) DEMANDE DE BREVET EUROPEEN

(21) Numéro de dépôt: **90200504.0**

(22) Date de dépôt: **05.03.90**

(51) Int. Cl.5: **H01J 37/20**

(30) Priorité: **10.03.89 FR 8903164**

(43) Date de publication de la demande:
**12.09.90 Bulletin 90/37**

(84) Etats contractants désignés:
**DE FR GB IT NL**

(71) Demandeur: **LABORATOIRES D'ELECTRONIQUE PHILIPS**
**3, Avenue Descartes**
**F-94450 Limeil-Brévannes(FR)**

(84) **FR**

Demandeur: **N.V. Philips' Gloeilampenfabrieken**
**Groenewoudseweg 1**
**NL-5621 BA Eindhoven(NL)**

(84) **DE GB IT NL**

(72) Inventeur: **Delarue, François, c/o Société Civile S.P.I.D.**
**209 rue de l'Université**
**F-75007 Paris(FR)**
Inventeur: **Girand, Michel, c/o Société Civile S.P.I.D.**
**209 rue de l'Université**
**F-75007 Paris(FR)**
Inventeur: **Montero, Manuel, c/o Société Civile S.P.I.D.**
**209 rue de l'Université**
**F-75007 Paris(FR)**

(74) Mandataire: **Landousy, Christian et al**
**Société Civile S.P.I.D. 156, Boulevard Haussmann**
**F-75008 Paris(FR)**

(54) **Micromanipulateur.**

(57) Micromanipulateur pour le déplacement d'un porte-échantillon selon différents degrés de liberté à l'aide d'organes de déplacement (26) fixés à des soufflets élastiques ($21_1, 21_2, 21_3, 23$) qui participent à la transmission de mouvements à travers une paroi (37). Au moins un mouvement de rotation du porte-échantillon est transmis à travers ladite paroi à l'aide d'une tige de transmission ($11_1, 11_2$) mobile en translation fixée à undit soufflet ($21_1, 21_2$). Au moins un mouvement de translation du porte-échantillon peut être également transmis par respectivement au moins une tige de transmission ($11_3$) mobile en translation.

Les tiges de transmission opèrent en translation parallèlement à une direction unique.

Le porte-échantillon peut se déplacer d'une part en translation et d'autre part en rotation selon une rotation dans son plan et selon une rotation par inclinaison dudit plan.

FIG. 2

## MICROMANIPULATEUR.

L'invention concerne un micromanipulateur pour le déplacement d'un porte-échantillon selon différents degrés de liberté à l'aide d'organes de déplacement montés sur des soufflets élastiques qui participent à la transmission des mouvements à travers une paroi.

Un tel micromanipulateur peut être utilisé sous vide ou ultravide ou dans des atmosphères contrôlées.

Un micromanipulateur de ce genre est décrit dans le document US 4 587 431. Il permet d'opérer sous ultra-vide le positionnement d'échantillons devant un faisceau. Le déplacement peut être effectué selon trois mouvements de translation orthogonaux et selon deux rotations : la rotation propre de l'échantillon par rapport à l'axe perpendiculaire à son plan ainsi qu'une rotation d'inclinaison de ce plan par rapport au faisceau. Pour opérer la transmission des commandes entre la zone sous atmosphère et la zone sous ultravide on utilise des soufflets élastiques. Pour la transmission des mouvements de translation de l'échantillon, les soufflets concernés sont mus à l'aide de moyens de transmission qui se déplacent en translation. Pour la transmission des mouvements de rotation de l'échantillon, les soufflets concernés sont mus à l'aide de moyens de rotation qui dans la zone sous ultravide sont transmis à l'aide d'un dispositif dit "en queue de cochon".

Mais un tel micromanipulateur est volumineux. De plus les soufflets qui transmettent les mouvements de rotation opèrent en torsion ce qui peut être préjudiciable à leur fonctionnement. En effet de telles actions répétées fragilisent les soufflets qui peuvent alors présenter des microfuites ou des fuites plus importantes ce qui a pour conséquence de limiter la durée de vie de ces soufflets.

Le problème posé par l'invention est de réaliser un micromanipulateur qui soit le plus compact possible, qui offre plusieurs degrés de liberté en translation et/ou en rotation avec de fortes amplitudes et une grande précision et qui transmet les commandes initiales en évitant d'exercer des forces de torsion sur les soufflets. Il doit assurer une position très stable de l'échantillon et pouvoir être aisément commandable de l'extérieur afin de permettre un fonctionnement programmable.

La solution à ce problème posé consiste en ce que au moins un mouvement de rotation du porte-échantillon est transmis à travers ladite paroi à l'aide d'une tige de transmission mobile en translation fixée à undit soufflet.

La rotation peut s'effectuer autour d'un axe perpendiculaire au plan de la face du porte-échantillon destinée à recevoir l'échantillon. La rotation peut aussi s'effectuer en inclinant ce plan par rapport à une position initiale.

Les organes de déplacement peuvent aussi faire subir au porte-échantillon des déplacements en translation soit dans le plan ou perpendiculaire à ladite face du porte-échantillon.

Le micromanipulateur est destiné en premier lieu à positionner un échantillon sous ultra-vide devant un appareil d'analyse tel qu'un analyseur par spectroscopie des photoélectrons issus de rayons X (X ray photoelectron spectroscopy XPS en langue anglaise). Mais il est possible de l'utiliser avec d'autres types d'appareils d'analyse ou pour d'autres milieux ambiants par exemple des atmosphères protégées. Il permet d'opérer avec des échantillons de grandes dimensions (donc de masse élevée pour ce type d'application) grâce aux grandes amplitudes de déplacement qu'il permet. Il est possible de positionner un point situé à la surface de l'échantillon par rapport à un faisceau d'analyse et de faire varier l'angle d'incidence en ce point. On peut également obtenir une rotation propre de l'échantillon.

L'invention sera mieux comprise à l'aide des figures suivantes données à titre d'exemple non limitatif qui représentent :

figure 1 : un schéma d'un micromanipulateur et d'un porte-échantillon disposant de deux déplacements en rotation et de deux déplacements en translation

figure 2 : un schéma d'un premier mode de réalisation d'un micromanipulateur selon l'invention comportant deux déplacements en rotation et deux déplacements en translation

figure 3 : un schéma d'un second mode de réalisation d'un micromanipulateur avec les mêmes degrés de liberté que pour la figure 1.

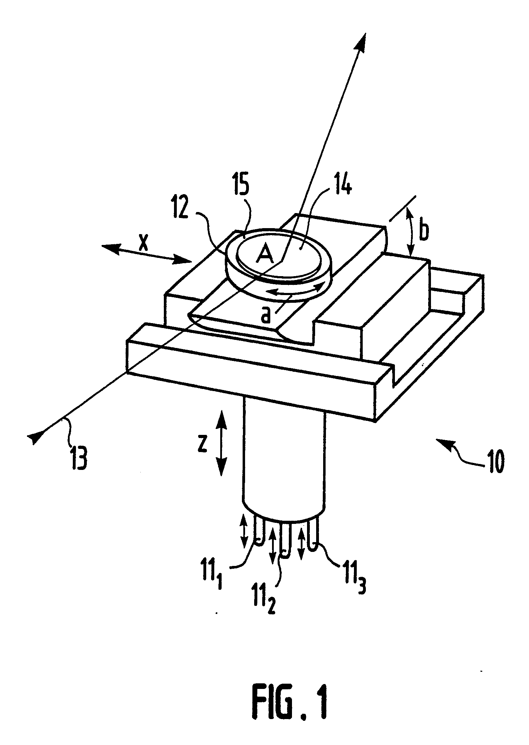

La figure 1 est un schéma très simplifié d'un micromanipulateur 10, pris à titre d'exemple, ayant 4 degrés de liberté. Sous l'action des tiges de transmission $11_1$, $11_2$, $11_3$, les organes de déplacement vont opérer une translation X, une rotation a et une rotation b du porte-échantillon 12 par rapport à un faisceau incident d'analyse 13. Un échantillon 14 est posé sur la face 15 du porte-échantillon 12. Le porte-échantillon peut subir une rotation a autour d'un axe perpendiculaire à la face 15. De même le porte-échantillon peut subir une rotation b qui incline la face 15 par rapport au faisceau incident 13. Les deux rotations s'effectuent autour du point d'impact A du faisceau 13, lorsque le point A est au croisement des deux axes de rotation.

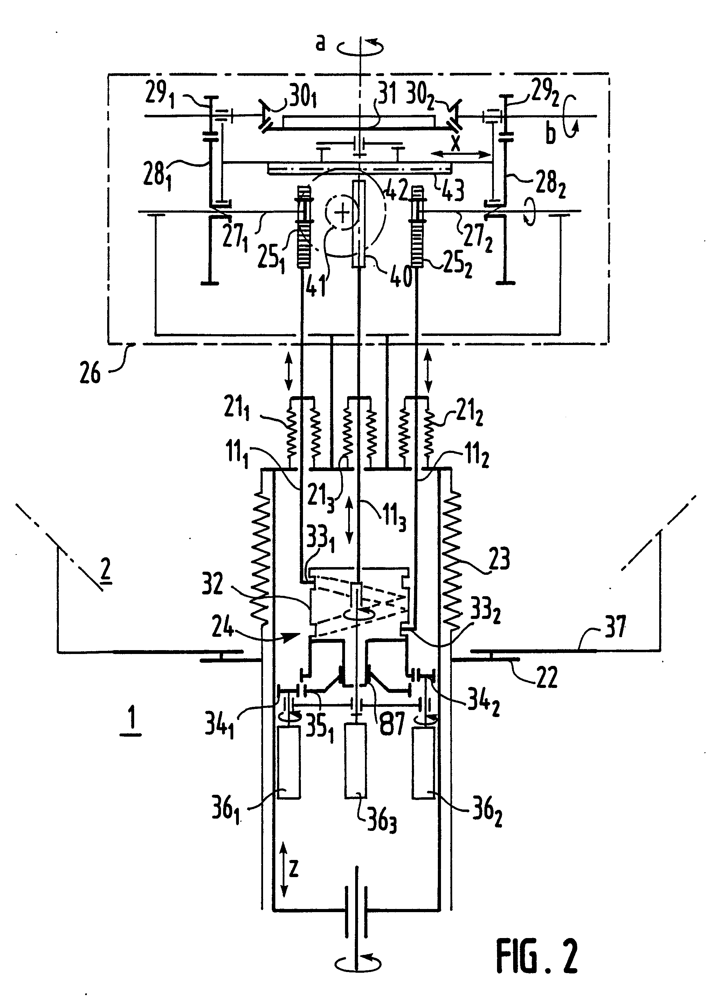

La figure 2 représente un schéma d'un premier mode de réalisation d'un micromanipulateur selon l'invention permettant d'assurer les 4 degrés de liberté indiqués sur la figure 1. Les tiges de transmission $11_1$, $11_2$, $11_3$ transmettent des mouvements de translation en faisant participer trois soufflets élastiques $21_1$, $21_2$, $21_3$. Ces soufflets sont destinés à assurer l'étanchéité entre deux zones 1, 2 isolées l'une de l'autre.

Dans le cas présent il s'agit d'un appareillage à ultra-vide, la zone 1 étant placée sous atmosphère et la zone 2 étant placée sous ultra-vide. La séparation est effectuée par les soufflets $21_1$, $21_2$, $21_3$ et par une bride 22 fixée sur une enceinte 37. Un autre soufflet 23, dont le rôle sera décrit ci-après, peut participer également à l'isolation des deux zones.

Les deux mouvements de rotation a et b sont assurés par les tiges $11_1$ et $11_2$ et le mouvement de translation par la tige $11_3$. Les tiges sont translatées par des moyens de translation 24 et elles agissent sur le porte-échantillon à l'aide d'organes de déplacement 26.

Pour opérer les deux rotations, les tiges $11_1$ et $11_2$ agissent respectivement sur des crémaillères $25_1$ et $25_2$. Chaque crémaillère $25_1$, $25_2$, à l'aide d'un arbre $27_1$, $27_2$, entraîne des pignons cylindriques $28_1$, $28_2$, $29_1$, $29_2$ et un pignon conique $30_1$, $30_2$. Ainsi pour transformer les translations des tiges de transmission en rotation du porte-échantillon, les organes de déplacement comprennent une crémaillère couplée à un pignon cylindrique muni d'un arbre qui entraîne au moins un pignon qui met en rotation le porte-échantillon.

Les deux pignons coniques $30_1$, $30_2$ peuvent tourner soit dans le même sens, soit dans des sens opposés et intervenir simultanément sur le support 31.

Cette double possibilité est permise en soumettant les tiges de transmission $11_1$, $11_2$ à des translations soit dans la même direction soit dans des directions opposées.

Ainsi les tiges de transmission peuvent se déplacer simultanément dans des directions opposées de sorte que les pignons engrennés au porte-échantillon tournent dans des sens de rotation différents provoquant ainsi une rotation du porte-échantillon autour d'un axe perpendiculaire à son plan.

De même les tiges de transmission peuvent se déplacer simultanément dans la même direction de sorte que les pignons engrennés au porte-échantillon tournent dans le même sens de rotation provoquant ainsi une rotation du porte-échantillon en inclinant son plan par rapport à une position initiale. Les sens de rotation des pignons sont décrits par rapport à une direction donnée.

Les translations des tiges de transmission sont imposées par des moyens de translation 24. Pour faire se déplacer les tiges de transmission $11_1$, $11_2$

dans des sens inversés, les moyens de translation 24 comprennent une vis 32 à double gorge à pas inversé. Les tiges $11_1$, $11_2$ possèdent à leur extrémité chacune un ergot $33_1$, $33_2$ qui se déplace respectivement dans l'une et l'autre gorge. Ainsi par la rotation dans un sens ou dans l'autre de la vis 32 il est possible de mettre le porte-échantillon en rotation dans un sens ou dans l'autre. La mise en rotation de la vis 32 est effectuée par le pignon $34_2$ commandé en rotation par le moteur $36_2$.

Pour obtenir le déplacement des tiges $11_1$ et $11_2$ dans la même direction il suffit de translater la vis 32 à l'aide de la vis 87 et des pignons $35_1$ et $34_1$. Un moteur $36_1$ peut mettre en rotation le pignon $34_1$.

Ainsi pour générer deux rotations du porte-échantillon à partir de commandes initiales de rotation, le micro-manipulateur comprend deux soufflets élastiques dont chaque tige de transmission est mise en translation par des moyens de translation qui comprennent, pour la translation inversée, un premier ergot solidaire de l'extrémité de la première tige qui se déplace dans une des gorges d'une vis à double gorge à pas inversé et un deuxième ergot solidaire de l'extrémité de la seconde tige qui se déplace dans l'autre gorge, la vis étant mue en rotation par les commandes initiales de rotation et pour la translation des tiges dans le même sens, un système à vis/écrou solidaire de la vis 32 et qui la déplace axialement. L'amplitude du déplacement des tiges est déterminée par les extrémités des deux gorges.

Il ne se produit ainsi aucune interférence entre les deux rotations a et b.

Le mouvement de translation de la face du support d'échantillon dans son plan dans une direction X est obtenu à l'aide de la tige de transmission $11_3$. Elle déplace une crémaillère 40 qui agit sur un pignon cylindrique 41 ayant le même axe qu'un pignon cylindrique 42 qui agit sur une crémaillère 43.

Ainsi pour transformer les translations des tiges de transmission en des translations du porte-échantillon dans une direction différente, les organes de déplacement comprennent pour une translation quelconque une crémaillère couplée à un pignon cylindrique coaxial avec un autre pignon cylindrique qui entraîne une autre crémaillère qui déplace en translation le porte-échantillon.

Il est possible de doubler le nombre d'éléments pour translater le porte-échantillon dans deux directions différentes X et Y. Les tiges de transmission qui opèrent les translations du porte-échantillon se déplacent en translation parallèlement à la direction unique.

La tige de transmission $11_3$ peut être déplacée en translation à partir de commandes initiales de rotation qui sont transformées à l'aide d'un mécanisme à vis et écrou mobiles.

Il est possible que le porte-échantillon subisse soit des déplacements en rotation soit des déplacements en translation.

Il est également possible de combiner ces deux types de déplacement, pour cela les arbres $27_1$, $27_2$ sont cannelés de sorte que les pignons $28_1$, $28_2$, $29_1$, $29_2$, $30_1$, $30_2$ et le plateau 31 peuvent glisser le long de ces arbres lorsque la crémaillère 40 impose un mouvement de translation au porte-échantillon.

Ainsi les organes de déplacement peuvent faire subir au porte-échantillon des déplacements en rotation et des déplacements en translation, l'arbre qui communique la rotation au porte-échantillon étant cannelé pour assurer un glissement longitudinal, sur sa périphérie, des pignons qu'il entraîne.

Selon le schéma de la figure 1 on obtient un micromanipulateur pour lequel les réglages en rotation a et b sont indépendants c'est-a-dire qu'une légère modification d'un des réglages n'a pas d'incidence sur l'autre.

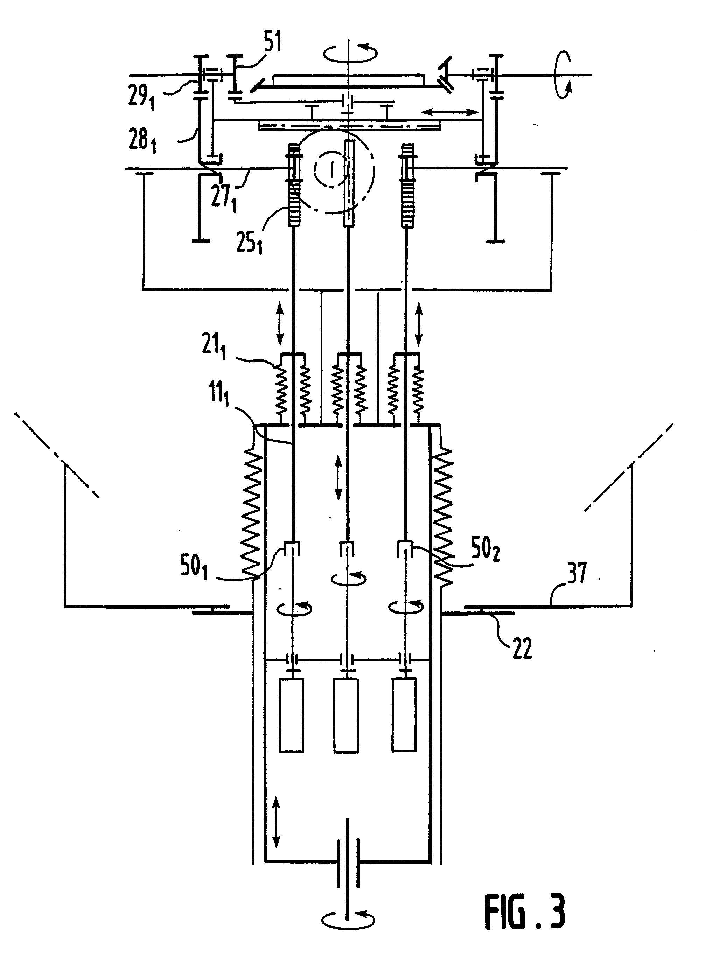

Selon la figure 3 il est possible de disposer d'une réalisation simplifiée où cette caractéristique n'est pas totalement satisfaite. Dans ce cas une modification d'un des réglages en rotation nécessite de retoucher l'autre réglage en rotation. La figure 3 reprend toutes les caractéristiques de la figure 2 à l'exception des points suivants qui concernent uniquement les 2 rotations.

Les moyens de translation ne possèdent plus la vis 32. Les tiges $11_1$ et $11_2$ sont commandées individuellement. Elles disposent pour cela chacune d'un mécanisme à vis/écrou mobiles $50_1$, $50_2$ pour opérer à partir de commandes initiales de rotation.

Les organes de déplacement ne possèdent plus le pignon conique $30_1$ opérant en coopération avec le pignon $30_2$. Sur la figure 3, le pignon $30_1$ est remplacé par un pignon droit 51 qui est entraîné par les pignons $29_1$, $28_1$, par l'axe 27, et la crémaillère $25_1$.

Pour permettre un déplacement selon une direction Z perpendiculaire, (lorsque celle-ci n'est pas inclinée), à la face 15 (figure 1) du porte-échantillon, il est possible de placer les trois soufflets $21_1$, $21_2$, $21_3$ sur un soufflet 23 qui se déplace également en translation dans la même direction. Ainsi l'ensemble constitué par les organes de déplacement 26, les soufflets $21_1$, $21_2$, $21_3$, les tiges de transmission $11_1$, $11_2$, $11_3$ et les moyens de translation 24 peuvent en bloc se déplacer dans la direction Z.

Les commandes initiales qui actionnent les tiges de transmission $11_1$, $11_2$, $11_3$ peuvent être des commandes de translation. Elles peuvent être générées par des vérins.

Préférentiellement les moyens de translation 24 sont destinés à générer un mouvement de translation des tiges de transmission $11_1$, $11_2$, $11_3$ à partir de commandes initiales en rotation comme cela a été décrit ci-dessus.

Dans ce cas les commandes initiales en rotation peuvent être générées par des moteurs. Ceci permet une programmation du fonctionnement du micromanipulateur.

Un tel micromanipulateur peut recevoir des échantillons d'un diamètre de 50,8 mn avec une rotation a dans le plan variant de 0 à 360° avec une précision de ± 0,1°. La rotation b peut être effectuée entre -30° et 60° avec une précision de ± 0,1°. La translation X atteint ± 12,5 avec une précision de ± 0,02 mm et la translation Z peut atteindre 100 mm avec une précision de ± 5 microns. Il peut supporter des températures atteignant environ 150°C. Le porte-échantillon peut être isolé électriquement à l'aide d'une plaque céramique fixée au porte-échantillon 31. Les axes de rotation sont alors définis en conséquence.

## Revendications

1. Micromanipulateur pour le déplacement d'un porte-échantillon selon différents degrés de liberté à l'aide d'organes de déplacement montés sur des soufflets élastiques qui participent à la transmission de mouvements à travers une paroi caractérisé en ce que au moins un mouvement de rotation du porte-échantillon est transmis à travers ladite paroi à l'aide d'une tige de transmission mobile en translation fixée à undit soufflet.

2. Micromanipulateur selon la revendication 1 caractérisé en ce que pour transformer la translation de la tige de transmission en une rotation du porte-échantillon, les organes de déplacement comprennent une crémaillère couplée à un pignon cylindrique muni d'un arbre qui entraîne au moins un pignon qui met en rotation le porte-échantillon.

3. Micromanipulateur selon la revendication 2 caractérisé en ce qu'il permet deux rotations du porte-échantillon à l'aide de deux tiges de transmission opérant en translation parallèlement à une direction unique.

4. Micromanipulateur selon la revendication 3 caractérisé en ce que les tiges de transmission se déplacent simultanément dans la même direction de sorte que les pignons engrennés au porte-échantillon tournent dans le même sens de rotation provoquant ainsi une rotation du porte-échantillon en inclinant son plan par rapport à une position initiale.

5. Micromanipulateur selon les revendications 3 ou 4 caractérisé en ce que les tiges de transmission se déplacent simultanément dans des directions opposées de sorte que les pignons engrennés au porte-échantillon tournent dans des sens de rotation différents provoquant ainsi une rotation du porte-échantillon autour d'un axe perpendiculaire à son plan.

6. Micromanipulateur selon la revendication 5 caractérisé en ce que pour générer deux rotations du porte-échantillon à partir de commandes initiales de rotation, le micromanipulateur comprend deux soufflets élastiques dont chaque tige de transmission est mise en translation par des moyens de translation qui comprennent pour la translation inversée un premier ergot solidaire de l'extrémité de la première tige qui se déplace dans une des gorges d'une vis à double gorge à pas inversé et un deuxième ergot solidaire de l'extrémité de la seconde tige qui se déplace dans l'autre gorge, la vis étant mue en rotation par les commandes initiales de rotation et pour la translation des tiges dans le même sens, un système à vis/écrou solidaire de la vis et qui la déplace axialement.

7. Micromanipulateur selon les revendications 4 à 6 caractérisé en ce que les mouvements des tiges de transmission selon les revendications 4 et 5 sont permutés.

8. Micromanipulateur selon une des revendications 2 à 6 caractérisé en ce que les moyens de translation transforment des commandes initiales de rotation à l'aide d'un mécanisme à vis et écrou mobile.

9. Micromanipulateur selon une des revendications 1 à 8 caractérisé en ce que les organes de déplacement sont reliés aux soufflets par des tiges de transmission mues en translation qui opèrent au moins une translation du porte-échantillon, un organe de déplacement pour une translation quelconque comprenant une crémaillère couplée à un pignon cylindrique coaxial avec un autre pignon cylindrique qui entraîne une autre crémaillère qui déplace en translation le porte-échantillon.

10. Micromanipulateur selon la revendication 9 caractérisé en ce que les tiges de transmission qui opèrent les translations du porte-échantillon se déplacent en translation parallèlement à ladite direction unique.

11. Micromanipulateur selon une des revendications 9 ou 10 caractérisé en ce que les tiges de transmission sont déplacées en translation à partir de commandes initiales de rotation qui sont transformées à l'aide d'un mécanisme à vis et écrou mobiles.

12. Micromanipulateur selon une des revendications 1 à 11 caractérisé en ce que au moins une commande initiale est une commande de translation obtenue à l'aide d'un vérin.

13. Micromanipulateur selon une des revendications 1 à 12 caractérisé en ce que au moins une commande initiale de rotation est obtenue à l'aide d'un moteur.

14. Micromanipulateur selon une des revendications 1 à 13 caractérisé en ce que les organes de déplacement font subir au porte-échantillon des déplacements en rotation et des déplacements en translation, l'arbre qui communique la rotation au porte-échantillon, étant cannelé pour assurer un glissement longitudinal, sur sa périphérie, des pignons qu'il entraîne.

15. Micromanipulateur selon la revendication 14 caractérisé en ce que le porte-échantillon est mobile en translation dans au moins une direction et en rotation selon une rotation dans son plan et selon une rotation qui incline ledit plan.

16. Micromanipulateur selon une des revendications 1 à 15 caractérisé en ce que les moyens de translation des tiges de transmission sont montés sur un soufflet mobile qui assure une translation du porte-échantillon selon une direction Z.

# FIG.1

FIG. 2

EP 0 386 840 A1

2—Ⅲ—PHF 89—516

FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,Y | US-A-4587431 (UEMURA)<br>* colonne 4, lignes 28 - 48; figures 2-4 *<br>--- | 1, 13 | H01J37/20 |
| Y | NUCLEAR INSTRUMENTS AND METHODS<br>vol. 147, no. 2, décembre 1977, North-Holland Publishing Co.<br>pages 349 - 351; O. AUCIELLO et al.:<br>"A novel ultra-high vacuum manipulator with six degrees of freedom"<br>* page 349, alinéa 4 * | 1, 13 | |
| A | | 3 | |
| A | US-A-3702399 (LUCAS)<br>* colonne 3, lignes 34 - 54 *<br>* colonne 3, ligne 62 - colonne 4, ligne 3 *<br>--- | 2 | |
| A | US-A-3474246 (O WOLFF ET AL)<br>* colonne 4, lignes 55 - 75 *<br>* colonne 6, lignes 43 - 48 *<br>* colonne 6, lignes 72 - 75 *<br>--- | 6 | |
| A | US-A-4447731 (KUNI ET AL)<br>* colonne 3, lignes 14 - 19; figure 4 *<br>----- | 8, 11 | **DOMAINES TECHNIQUES RECHERCHES (Int. Cl.5)**<br><br>H01J37/00<br>B25J1/00<br>B25J7/00<br>B25J21/00 |

Le présent rapport a été établi pour toutes les revendications

| Lieu de la recherche | Date d'achèvement de la recherche | Examinateur |
|---|---|---|
| LA HAYE | 06 JUIN 1990 | COLVIN G.G. |